# EUROPEAN PATENT SPECIFICATION

(11) **EP 4 429 447 B1**
(45) Date of publication and mention of the grant of the patent: **06.05.2026**
(21) Application number: 24151867.9
(22) Date of filing: 15.01.2024
(51) Int. Cl.: H10N 50/01, H10N 50/10, H10N 50/85, G11C 11/16, H01F 10/30, H10B 61/00

(54) **TEMPLATING LAYERS FOR SPIN ORBIT TORQUE ASSISTED SWITCHING OF PERPENDICULARLY MAGNETIZED HEUSLER FILMS**
WACHSTUMSSCHICHTEN ZUM SPIN-ORBIT-UNTERSTÜTZTEN SCHALTEN VON SENKRECHT MAGNETISIERTEN HEUSLERSCHICHTEN
COUCHES DE CALIBRAGE POUR COMMUTATION ASSISTÉE PAR COUPLE D'ORBITE DE SPIN DE FILMS DE HEUSLER MAGNÉTISÉS PERPENDICULAIREMENT

(30) Priority: 07.03.2023 US 202318179646
(43) Date of publication of application: 11.09.2024
(73) Proprietor: Samsung Electronics Co., Ltd., Suwon-si, Gyeonggi-do 16677 (KR); International Business Machines Corporation, Armonk, New York 10504 (US)
(72) Inventor: IKHTIAR,, San Jose, CA, 95134 (US); GARG, Chirag, San Jose, CA, 95120 (US); JEONG, Jaewoo, San Jose, CA, 95134 (US); FILIPPOU, Panagiotis Charilaos, San Jose, CA, 95120 (US); SAMANT, Mahesh, San Jose, CA, 95120 (US); YANG, See-Hun, San Jose, CA, 95120 (US)
(74) Representative: Kuhnen & Wacker Patent- und Rechtsanwaltsbüro PartG mbB

(56) References cited:
- EP-A1- 4 027 344
- US-A1- 2018 287 052
- GRUSHKO B ED - BATTEZZATI LIVIO ET AL: "On the constitution of Al-Pt-(Pd or Ni) around 50at.% Al", JOURNAL OF ALLOYS AND COMPOUNDS, vol. 541, 30 June 2012 (2012-06-30), pages 88 - 93, XP028938060, ISSN: 0925-8388, DOI: 10.1016/J.JALLCOM.2012.06.114

## Description

### BACKGROUND

The present disclosure relates to magnetic random access memory (MRAM) devices, and, more specifically, optimizing the tunnel magnetoresistance (TMR) and switching currents of a magnetic tunneling junction (MTJ) device with a Heusler layer in a MRAM stack.

EP 4 027 344 A1 discloses a magnetic structure, a magnetic device incorporating the magnetic structure and a method for providing the magnetic structure are described. The magnetic structure includes a magnetic layer, a templating structure and a resistive insertion layer. The magnetic layer includes a Heusler compound and has a perpendicular magnetic anisotropy energy exceeding an out-of-plane demagnetization energy. The templating structure has a crystal structure configured to template at least one of the Heusler compound and the resistive insertion layer. The magnetic layer is on the templating structure. The resistive insertion layer is configured to reduce magnetic damping for the Heusler compound and allow for templating of the Heusler compound.

Further prior art is disclosed in Grushko B., "On the constitution of Al-Pt-(Pd or Ni) around 50at.% Al", Journal of Alloys and Compounds, 541, 88-93 (2012).

Many known magnetic memory devices, for example, magnetic random access memory (MRAM) devices, are storage elements that store information utilizing magnetic materials as the information storage medium. Many of these known MRAM devices include a magnetic tunneling junction (MTJ) that is typically a structure that includes three distinct layers, i.e., a magnetic reference layer and a magnetic free layer with an insulating tunneling barrier therebetween. When electric current is transmitted through the MRAM device, the resistance of the MTJ typically depends on the relative orientation of magnetization of the two magnetic layers, and the relative change in resistance is referred to as the tunnel magnetoresistance (TMR). In at least some known MTJs, the free layer is formed from a Heusler compound (or alloy).

Some known MTJs employ a spin transfer torque (STT) effect to define STT-MRAM devices. The STT effect facilitates the toggling, i.e., switching of magnetic orientation of the free layer of the MTJ. The electrons that define an electric current have the intrinsic quantum mechanical property of spin that is associated with the spin angular momentum of the electrons. By passing electrons perpendicularly through the fixed reference layer, a spin-polarized current is produced, where the current has a spin-polarized angular momentum. When this spin-polarized current is directed into the free layer, at least a portion of the spin-polarized angular momentum of the respective electrons is transferred to the free layer, thereby applying a spin transfer torque (STT) to the magnetic moments in the free layer. Changing, i.e., flipping (toggling or switching) the orientation of the respective magnetic moment is achieved when the spin transfer torque is of sufficient magnitude.

Some known MRAM devices and their respective MTJs use an additional mechanism, i.e., spin orbit torque (SOT) to facilitate operation of SOT-MRAM devices that also employ the STT mechanism. One mechanism for inducing spin orbit torque is through coupling a nonmagnetic heavy metal material to the magnetic layer, i.e., the free layer, where the nonmagnetic layer (sometimes referred to as the SOT layer) induces a large spin orbit coupling (or interaction) between the spin of the electrons and the motion of the respective electron charges. Such spin orbit coupling induces the spin Hall effect (SHE), where electrons with different spins deflect in different directions yielding a pure injected spin current transverse to an applied charge current (read or write), similar to the well-known Hall effect. The polarized spin-currents that accumulate on opposite sides of the non-magnetic layer induce an additional torque on the free layer, i.e., the spin-orbit torque. The addition of the spin orbit torque induced by the non-magnetic layer on the coupled magnetic free layer to the spin transfer torque further decreases the necessary current for switching the respective MTJ.

### SUMMARY

The invention is set out in the appended claims.

A system and method are provided for optimizing the tunnel magnetoresistance (TMR) and switching currents of a magnetic tunneling junction (MTJ) device with a Heusler layer in a MRAM stack.

In one aspect, a magnetic random access memory (MRAM) stack is presented. The MRAM device includes a first magnetic layer including a Heusler compound. The MRAM stack also includes one or more seed layers that include a templating structure including a crystalline structure. The first magnetic layer is formed over the templating structure. The templating structure includes a layer of a binary alloy including platinum-aluminum (PtAl). The desired reduction in the switching current of an MTJ in the MRAM stack is achieved through assisting the spin transfer torque (STT) with a simultaneous contribution from the spin orbit torque (SOT) through leveraging the spin Hall effect through the PtAl layer.

In another aspect, a method of fabricating a magnetic random access memory (MRAM) stack is presented. The method includes forming one or more seed layers that includes forming a templating structure above a substrate. The templating structure includes a crystalline structure. The forming the templating structure includes forming a layer of a binary alloy including platinum-aluminum (PtAl). The method also includes forming a first magnetic layer including templating a Heusler compound through the templating structure. The desired reduction in the switching current of an MTJ in the MRAM stack is achieved through assisting the spin transfer torque (STT) with a simultaneous contribution from the spin orbit torque (SOT) through leveraging the spin Hall effect through the PtAl layer.

In yet another aspect, a magnetic random-access memory (MRAM) array is presented. The MRAM array includes a plurality of bit lines and a plurality of corresponding complementary bit lines forming a plurality of bit line-complementary bit line pairs. The MRAM array also includes a plurality of word lines intersecting the plurality of bit line pairs at a plurality of cell locations. The MRAM array further includes a plurality of MRAM cells located at each cell location of the plurality of cell locations. Each MRAM cell of the plurality of MRAM cells is electrically connected to a corresponding bit line of the plurality of bit lines and selectively interconnected to a corresponding one of the plurality of the complementary bit lines under control of a corresponding one of the word lines of the plurality of word lines. Each MRAM cell of the plurality of MRAM cells includes a first magnetic layer including a Heusler compound. Each MRAM cell also includes one or more seed layers including a templating structure including a crystalline structure configured to template the Heusler compound. The first magnetic layer is formed over the templating structure. The templating structure includes a layer of a first binary alloy including platinum-aluminum (PtAl). The desired reduction in the switching current of an MTJ in the MRAM stack is achieved through assisting the spin transfer torque (STT) with a simultaneous contribution from the spin orbit torque (SOT) through leveraging the spin Hall effect through the PtAl layer.

In yet another aspect, a computer system is presented. The computer system includes one or more processing devices, and one or more memory devices communicatively and operably coupled to the one or more processing devices. At least one memory device of the one or more memory devices includes one or more magnetic random access memory (MRAM) devices. Each MRAM device of the one or more MRAM devices includes a first magnetic layer including a Heusler compound. Each MRAM device also includes one or more seed layers including a templating structure including a crystalline structure configured to template the Heusler compound. The first magnetic layer is formed over the templating structure. The templating structure includes a layer of a binary alloy including platinum-aluminum (PtAl). The desired reduction in the switching current of an MTJ in the MRAM stack is achieved through assisting the spin transfer torque (STT) with a simultaneous contribution from the spin orbit torque (SOT) through leveraging the spin Hall effect through the PtAl layer.

In yet another aspect, a magnetic random-access memory (MRAM) device is presented. The MRAM device includes a plurality of MRAM stacks. Each MRAM stack of the plurality of MRAM stacks includes a first magnetic layer including a Heusler compound. Each MRAM stack also includes one or more seed layers including a templating structure including a crystalline structure configured to template the Heusler compound. The first magnetic layer is formed over the templating structure. The templating structure includes a layer of a binary alloy including platinum-aluminum (PtAl). The desired reduction in the switching current of an MTJ in the MRAM stack is achieved through assisting the spin transfer torque (STT) with a simultaneous contribution from the spin orbit torque (SOT) through leveraging the spin Hall effect through the PtAl layer.

The present Summary is not intended to illustrate each aspect of every implementation of, and/or every embodiment of the present disclosure. These and other features and advantages will become apparent from the following detailed description of the present embodiment(s), taken in conjunction with the accompanying drawings.

### BRIEF DESCRIPTION OF THE DRAWINGS

The drawings included in the disclosure are incorporated into, and form part of, the specification. They illustrate embodiments of the present disclosure and, along with the description, serve to explain the principles of the disclosure. The drawings are illustrative of certain embodiments and do not limit the disclosure.
FIG. 1 is a block schematic diagram illustrating a magnetic random access memory (MRAM) stack, in accordance with some embodiments of the present invention.
FIG. 2 is a simplified block schematic diagram illustrating portions of the MRAM stack of FIG. 1 and the respective magnetic moments, in accordance with some embodiments of the present invention.
FIG. 3 is a simplified block schematic diagram illustrating portions of the MRAM stack of FIGs. 1 and 2 and the respective magnetic moments, in accordance with some embodiments of the present invention.
FIG. 4 is a flowchart illustrating a process for fabricating a MRAM device, in accordance with some embodiments of the present invention.
FIG. 5 is a block schematic diagram illustrating a MRAM array, in accordance with some embodiments of the present disclosure.
FIG. 6 is a block schematic diagram illustrating a computing system, in accordance with some embodiments of the present disclosure.
FIG. 7 is a block schematic diagram illustrating a three-terminal SOT-MRAM device, in accordance with some embodiments of the present disclosure.
FIG. 8 is a block schematic diagram illustrating a two-terminal SOT-MRAM device, in accordance with some embodiments of the present disclosure.

### DETAILED DESCRIPTION

Aspects of the present disclosure relate to optimizing the tunnel magnetoresistance (TMR) and switching currents of a magnetic tunneling junction (MTJ) device with a Heusler layer in a MRAM stack. While the present disclosure is not necessarily limited to such applications, various aspects of the disclosure may be appreciated through a discussion of various examples using this context.

It will be readily understood that the components of the present embodiments of the present invention and of the present disclosure, as generally described and illustrated in the Figures herein, may be arranged and designed in a wide variety of different configurations. Thus, the following details description of the embodiments of the apparatus, system, method, and computer program product of the present embodiments, as presented in the Figures, is not intended to limit the scope of the embodiments, as claimed, but is merely representative of selected embodiments.

Reference throughout this specification to "a select embodiment," "at least one embodiment," "one embodiment," "another embodiment ," "other embodiments," or "an embodiment" and similar language means that a particular feature, structure, or characteristic described in connection with the embodiment is included in at least one embodiment. Thus, appearances of the phrases "a select embodiment," "at least one embodiment," "in one embodiment," "another embodiment," "other embodiments," or "an embodiment" in various places throughout this specification are not necessarily referring to the same embodiment.

The illustrated embodiments will be best understood by reference to the drawings, wherein like parts are designated by like numerals throughout. The following description is intended only by way of example, and simply illustrates certain selected embodiments of devices, systems, and processes that are consistent with the embodiments as claimed herein.

As used herein, "facilitating" an action includes performing the action, making the action easier, helping to carry the action out, or causing the action to be performed. Thus, by way of example and not limitation, instructions executing on one processor might facilitate an action carried out by semiconductor processing equipment, by sending appropriate data or commands to cause or aid the action to be performed. Where an actor facilitates an action by other than performing the action, the action is nevertheless performed by some entity or combination of entities.

Many known magnetic memory devices, for example, magnetic random access memory (MRAM) devices, are storage elements that store information utilizing magnetic materials as the information storage medium. At least some of these known MRAM devices are configured as a layered stack (or pillar), where at least a portion of the stack is fabricated through known deposition and templating methods. Referencing a stack configuration, the terms "up" and "down," "lower" and "upper," and "top" and "bottom" are frequently used. Many of these known MRAM devices include a magnetic tunneling junction (MTJ) that is typically a structure that includes three distinct layers, i.e., a magnetic reference layer and a magnetic free layer (sometimes referred to as a "storage layer") with an insulating tunneling barrier therebetween. The thickness of each of these three layers is typically measured in Angstroms (Å). When electric current is transmitted through the MRAM device, the resistance of the MTJ depends on the magnetic orientation of the two magnetic layers, and the relative change in resistance between the parallel and anti-parallel orientations of the magnetization is referred to as the tunnel magnetoresistance (TMR), which in some cases is expressed in units of percentage change. In most applications, a higher TMR is preferred over a lower TMR.

The direction of the current flow through the stack is typically reversible. Specifically, the electrical conductivity features of the stack above and below the MTJ are used to drive current through the MTJ in a current-perpendicular-to-plane (CPP) direction. Therefore, it is advantageous for such MTJs, and more specifically, the magnetic layers, to have perpendicular magnetic anisotropy (PMA) as smaller switching currents are required as compared to in-plane magnetized MTJs. As such, for MTJs for MRAM applications, it is desirable that substantially all the magnetic elements have their moments perpendicular to the layer itself, i.e., magnetization perpendicular to the film plane and the PMA arising from the crystalline structure, with the magnetic moments of the magnetic layer perpendicular to the layer. For example, in the case of MTJs with a positive tunnel magnetoresistance (TMR), i.e., when a sufficient current is driven in a top-to-bottom CPP direction, where the free layer is above the tunnel barrier with the reference layer below the tunnel barrier, and, by convention, the current direction is opposite to the electron flow direction and the initial state of the MTJ is anti-parallel state, the free layer magnetic moment switches to be parallel to that of the reference layer, thereby defining a low resistance to current flow within the MTJ device. In the parallel configuration, the two magnetic layers have their magnetizations aligned with each other, and the resistance is typically lower in this state relative to the anti-parallel configuration, discussed as follows.

In at least some known MTJs, the free layer is formed from a Heusler compound (or alloy). Reference herein to Heusler or Heuslers without the term "half" is intended to reference full-Heuslers. Some Heusler compounds are magnetic intermetallic substances and a subset of these have a tetragonal configuration, a relatively large volume PMA, and a low magnetic moment that requires lower switching currents. The free layer is typically formed, i.e., grown epitaxially, through a templating layer that facilitates proper growth of the free layer. One such Heusler compound is manganese-germanium (Mn₃Ge). One known method of inducing PMA in a magnetic Heusler compound includes modifying the compound from an originally cubic crystalline configuration to a tetragonal crystalline configuration. Therefore, instead of having all three unit cell lattice parameters to be of the same length, if one of the lattice parameters is a little longer (or shorter), then, because of breaking of the crystal symmetry, the magnetization can be tuned to be perpendicular.

In the tetragonal case, for example, where some Heusler compounds have a tetragonal ground state (e.g., Mn₃Ge), the compound shows PMA if the tetragonal axis of the compound is along the Z-axis, i.e., perpendicular to the film plane, where an out-of-plane lattice parameter is longer (or shorter) than the in-plane lattice parameters. In addition, it may be desirable that magnetic materials have volume PMA rather than surface (interfacial) PMA, as this enables scaling of devices to smaller sizes (typically smaller diameter). As device size is reduced, the devices become less thermally stable. However, for devices with volume anisotropy, it is advantageously possible to compensate for the lowering of thermal stability by increasing the thickness. The switching current is proportional to the product (Mₛ * V * Hₖ), where Mₛ is saturation magnetization, V is volume, and Hₖ is the anisotropy field. Low moment (i.e., low Mₛ) Heusler compounds need lower switching currents, unless the increase in Hₖ overwhelms the lower Mₛ. In the tetragonal case, the Z (vertical) axis is "stretched" (shrinking is also possible in alternative approaches) relative to the cubic case. If the Heusler layer is grown with a Z-axis perpendicular to the (x-y) plane of the film, on a suitable templating layer, the Heusler layer will have a moment which is perpendicular to the (x-y) plane of the film. Accordingly, the tetragonality and the associated PMA facilitates suitability for use in perpendicular MTJs.

One additional known method of enhancing the TMR of the Heusler compounds include using templating materials, such as materials with a CsCl-like (cesium-chloride-like) structure, i.e., a crystalline structure that defines a substantially continuous lattice with each cubical unit including a cesium atom surrounded by 8 chlorine atoms, i.e., one Cl atom at each corner of the cube, to further define a body-centered cubic (BCC) unit cell structure. The CsCl-like templating materials grown with (001) orientation have alternating layers of Cs and Cl. Two examples of such CsCl-like chemical templating layers (CTL) includes cobalt-aluminum (CoAl) and iridium-aluminum (IrAl) alloys, or together defining bi-layer templating materials. The templating materials may include a single layer structure and a multi-layered structure.

As described above, high TMR is desirable since the higher TMR provides a higher ON/OFF ratio and a resultant higher signal-to-noise ratio for determination of the MTJ state. Therefore, there is a need to implement further upward improvements of the TMR of the Heusler compounds to enhance the performance of the MTJs to further reduce the power consumption of the MRAM devices. Accordingly, fabrication enhancements to the memory stacks to overcome the technical limitations present in the state-of-the-art memory stack fabrication processes to enhance the polarization of the electron spin is desirable.

Some MTJs employ a spin transfer torque (STT) effect, and are also non-volatile STT-MRAM devices that have lower power consumption advantages over charge-based memory devices, such as static RAM (SRAM) and dynamic RAM (DRAM). The STT effect facilitates the toggling, i.e., switching of magnetic orientation of the free layer of the MTJ. More specifically, the magnetic moment of the reference layer is generally fixed, or pinned, in a particular direction. The free layer has a changeable magnetic moment and is used to store information with the data state of either a "1" or a "0." The electrons that define an electric current have the intrinsic quantum mechanics property of spin that is associated with the spin angular momentum of the electrons. The electron spin will have one of two distinct quantum states, i.e., spin-up (+1/2) and spin-down (-1/2). In general, an electric current is unpolarized, i.e., consisting of approximately 50% spin-up electrons and approximately 50% spin-down electrons. A spin-polarized current is one with more electrons of either spin state. By passing electrons through the fixed reference layer, a spin-polarized current is produced, where the current has a spin-polarized angular momentum. When this spin-polarized current is directed into the free layer, the polarized angular momentum is transferred to the free layer, thereby applying a torque to the free layer and changing, i.e., flipping (toggling or switching) the orientation of the respective magnetic field. Flipping the orientation of the magnetic field will flip the data state of the free layer. As described further herein, this description explains the change in magnetization of the free layer when it is anti-parallel to the reference layer, and to change the magnetization from the parallel to anti-parallel state, the direction of the electron flow is reversed. Accordingly, a spin-polarized current can switch the magnetization direction of the free layer if the current density is sufficiently high, and if the dimensions of the multilayer are sufficiently small.

The TMR is related to the spin polarization, i.e., typically high spin polarization leads to high TMR. High spin polarization, and thus high TMR, is desirable, since the higher TMR provides a higher ON/OFF ratio. When a sufficient current is driven in the opposite direction (e.g., bottom to top), the free layer magnetic moment switches to be anti-parallel to that of the reference layer, thereby defining a high resistance to current flow within the MTJ device. In the anti-parallel state, the magnetic layers do not have their magnetizations aligned with each other, and the resistance is typically higher in this state relative to the parallel configuration. Therefore, the magnetic state of the MTJ is changed by passing an electric current through it. The current delivers spin angular momentum, so that once a threshold current is exceeded, the direction of the memory layer moment is switched. Accordingly, different current directions define different spin-polarized currents to generate different magnetic configurations corresponding to different magnetoresistance states and thus different logical states, e.g., a logical "0" and a logical "1" of the MTJ.

Some known MRAM devices and their respective MTJs use an additional mechanism, i.e., spin orbit torque (SOT) to facilitate operation of SOT-MRAM devices that also employ the STT mechanism. One mechanism for inducing spin orbit torque is through coupling a nonmagnetic material to the magnetic layer, i.e., the free layer, where the nonmagnetic layer (sometimes referred to as the SOT layer) induces a large spin orbit coupling (or interaction) between the spin of the electrons and the motion of the respective electron charges. Such spin orbit coupling induces the spin Hall effect (SHE), where electrons with different spins deflect in different directions yielding a pure injected spin current transverse to an applied charge current, similar to the well-known Hall effect. More specifically, the spin-up electrons are preferentially scattered in one direction and the spin-down electrons are preferentially scattered in the opposite direction within the non-magnetic material, both with respect to the electron current and the magnetic spin orientation, where the two spin-polarized currents are perpendicular to the charge current, i.e., the spin-polarized currents are oriented in-plane within the non-magnetic layer. The polarized spin-currents that accumulate on opposite sides of the non-magnetic layer induce an additional torque on the free layer, i.e., the spin-orbit torque. The spin orbit torque is at least partially based on the total orbital angular momentum of the electrons, where the orbital momentum is at least partially dependent on the respective spin. The addition of the spin orbit torque induced by the non-magnetic layer on the coupled magnetic free layer to the spin transfer torque decreases the necessary current for switching the respective MTJ.

At least one method for reducing the switching current in an MRAM device is to replace an existing free layer of CoFeB with the aforementioned Heusler layer. At least some of the additional method of using a simultaneous contribution of SOT to supplement STT to decrease the switching current necessitates the use of one or more layers of one or more heavy metals in close proximity of the free layer is one candidate solution. However, the addition of one or more layers of SOT materials further increases the size of the MRAM stack. Therefore, a need exists to further decrease the switching current while decreasing the size of an associated control transistor which at least partially dictates the overall memory density.

Some known methods of using spin orbit torque (SOT) for MRAM include an SOT-MRAM array with directional spin-flipping without an external magnetic field (see CN111986717A). The SOT-MRAM sequentially comprises the following components from top to bottom: a gate (1) for turning on or off the SOT-MRAM by an applied voltage; a magnetic tunnel junction (2) sequentially comprising a ferromagnetic reference layer (201), a tunneling layer (202), and a ferromagnetic free layer (203) from top to bottom; and a spin orbit coupling layer (3) that is composed of one or more of heavy metal, doped heavy metal, heavy metal alloy, double metal layers, semiconductor material, two-dimensional semimetal material and antiferromagnetic material. An in-plane field is generated in the ferromagnetic free layer (203) by utilizing the interlayer exchange coupling effect, and spin orbit torque is generated by utilizing the spin Hall effect, so that data can be stored in the magnetic tunnel junction (2) in a deterministic manner. The method utilizes the vertical anisotropy of a ferromagnetic layer, realizes the SOT drive magnetic tunnel junction ferromagnetic free layer directional spin overturning, and realizes a three-dimensional array structure through the combined effect of interlayer exchange coupling and spin transfer torque without the assistance of an external magnetic field. However, at least some of these devices do not have templating capabilities, since the identified heavy metal for the spin orbit coupling layer (3) is a Pt-rich alloy, i.e., Pt₈₀Al₂₀. Notably, Pt₈₀Al₂₀ does not have a CsCl-like structure and does not have the ability to template a Heusler layer, since in this instance, a Heusler layer is not used.

In addition, known methods of using spin orbit torque (SOT) for MRAM (see US 2020/0403149) include a spintronic device that uses spin torque transfer, spin orbit torque, spin Hall effect, spin angular moment, and spin-polarized current. The device has a perpendicular magnetic tunnel junction, where a metal insertion (MIS) layer is formed within a free layer (FL), a partially oxidized Hₖ enhancing layer is on the FL, and a nitride capping layer having a buffer layer/nitride layer (NL) is on the Hₖ enhancing layer to provide an improved coercivity (H_{c})/switching current (J_{c}) ratio for spintronic applications. The magnetoresistive ratio is maintained above 100%, the resistance times area (RA) product is below 5 ohm/µm², and thermal stability to 400° C is realized. The FL comprises two or more sub-layers, and the MIS layer may be formed within at least one sub-layer or between sub-layers. The buffer layer is used to prevent oxygen diffusion to the NL, and nitrogen diffusion from the NL to the FL. FL thickness is from 11 Angstroms to 25 Angstroms while MIS layer thickness is preferably from 0.5 Angstroms to 4 Angstroms. Notably, the document is silent with respect to using a PtAl alloy as a chemical templating layer directly under a free layer.

Furthermore, as described in the non-patent literature (NPL) "Highly fcc-textured Pt-Al alloy films grown on MgO(001) showing enhanced spin Hall efficiency" as authored by Yong-Change Lau et al., known methods of using spin orbit torque (SOT) for MRAM include optimization of the spin Hall efficiency between highly face-centered cubic (fcc)-textured Pt-Al alloy films grown on magnesium oxide, i.e., MgO(001) and poorly-crystallized Pt-Al alloy films grown on SiO₂. Using CoFeB as the detector, it is shown that for Al compositions centering around x=25, mainly L1₂ ordered Pt₁₀₀₋ₓAlₓ alloy films grown on MgO exhibit outstanding charge-spin conversion efficiency. For Pt₇₈Al₂₂/CoFeB bilayer on MgO, damping-like spin Hall efficiency as high as ξ_{DL}~+0.20 is obtained and up to seven-fold reduction of power consumption may be expected compared to the polycrystalline bilayer of the same Al composition on SiO₂ may be expected. This work demonstrates that improving the crystallinity of fcc Pt-based alloys is a crucial step for achieving large spin Hall efficiency and low power consumption in this material class. Notably, the document is silent with respect to using a PtAl alloy with the associated CsCl structure rather than an fcc structure as a chemical templating layer directly under a free layer.

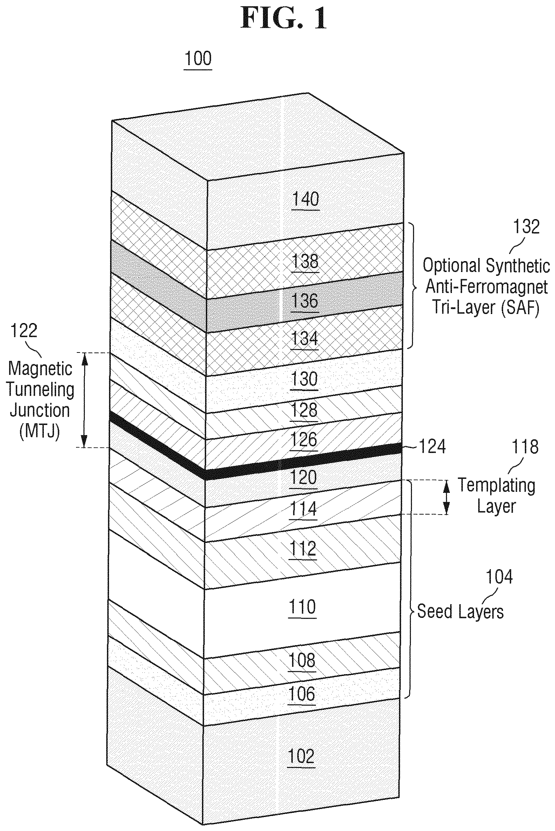

Referring to FIG. 1, a block schematic diagram is presented illustrating a spin orbit torque (SOT) switchable magnetic random access memory (MRAM) stack 100 (referred to as the MRAM stack 100 herein), in accordance with some embodiments of the present invention. For purposes of clarity, the components illustrated in FIG. 1 are not drawn to scale. In some embodiments, the MRAM stack 100 is approximately 100 nanometers (nm) in height, where, in general, the height is a non-limiting factor with respect to performance thereof, and, therefore, the MRAM stack 100 has any height that enables operation as described herein. As used herein, "in-plane" is substantially within or parallel to the plane of one or more of the layers of a magnetic tunnel junction. Conversely, "perpendicular" and "perpendicular-to-plane" corresponds to a direction that is substantially orthogonal to one or more of the layers of the magnetic tunnel junction. The method and system are also described in the context of certain alloys. However, unless otherwise specified, these listings of alloys are non-limiting, and if specific concentrations of the alloy are not mentioned, any stoichiometry that enables operation of the embodiments of the MRAM stack 100 as described herein that is not inconsistent with such embodiments may be used.

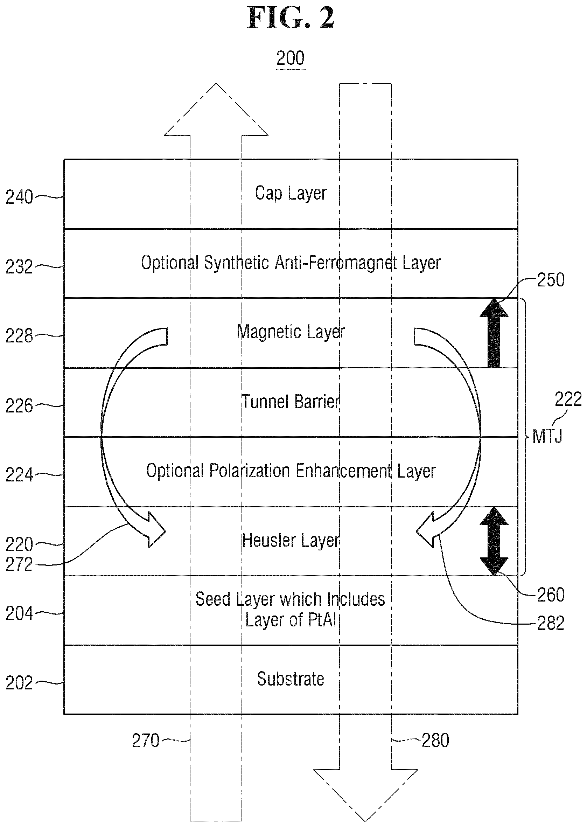

Also referring to FIG. 2, a simplified block schematic diagram is presented illustrating portions of the MRAM stack 200 (shown as the MRAM stack 100 in FIG. 1) and the respective magnetic moments, in accordance with some embodiments of the present invention. Similar components in both FIG. 1 and FIG. 2 have similar numbering.

In one or more embodiments, the MRAM stack 100 includes a silicon-based substrate layer 102 (shown as "Substrate 202" in FIG. 2) that is typically held at approximately room temperature, i.e., at approximately 20 degrees Celsius (°C) to approximately 25°C. The substrate layer 102 is configured to provide the proper electrical conductivity for the MRAM stack 100 as described further herein. In some embodiments, the substrate layer 102 includes one or more of silicon oxide (SiO₂), tantalum (Ta), and ruthenium (Ru). In some embodiments, the Si/SiO₂ portion (not shown) of the substrate layer 102 has any thickness, the Ta portion (not shown) of the substrate layer 102 is approximately 50 angstroms (Å) in thickness, and the Ru portion (not shown) of the substrate layer 102 is approximately 250 Å in thickness, where the thicknesses are presented in the vertical direction in FIG. 1. In some embodiments, the thicknesses of the Si, SiO₂, Ta, and Ru portions of the substrate layer 102 are any values that enable operation of the MRAM stack 100 as described herein.

In some embodiments, the substrate layer 102 is formed from magnesium oxide, i.e., MgO(001). In some embodiments, the thickness is in the range of approximately 10 Å and approximately 20 Å. In some embodiments, the thickness of the MgO(001) substrate layer 102 is approximately 15 Å.

In at least some embodiments, the MRAM stack 100 includes a plurality of seed (chemical templating) layers 104 (shown as 204 in FIG. 2), at least some that are deposited at approximately room temperature. In some embodiments, the seed layers 104 include a lower Ta layer 106 with a thickness of approximately 50 Å to approximately 100 Å that is formed to extend over the substrate layer 102, and to extend in the vertical direction. In some embodiments, the lower Ta layer 106 is not a portion of the seed layers 104. In addition, in some embodiments, the MRAM stack 100 includes a lower amorphous cobalt-iron-boron alloy (CoFeB) layer 108 formed to extend over the lower Ta layer 106, and to extend in the vertical direction, at approximately room temperature. In at least some embodiments, the CoFeB layer 108 is structured such that approximately 80% of the atoms in the compound are a CoFe alloy and approximately 20% of the atoms are boron, and is herein referred to as (CoFe)₈₀B₂₀. The boron (B) content of the lower (CoFe)₈₀B₂₀ 108 layer is not restricted to approximately 20% but can be varied and is typically in the range from approximately 15% to approximately 35%. This (CoFe)₈₀B₂₀ layer 108 is non-magnetic, at least partially as a consequence of it being ultra-thin. In some embodiments, the lower (CoFe)₈₀B₂₀ layer 108 has a thickness of approximately 5 Å. In some embodiments, the lower (CoFe)₈₀B₂₀ layer 108 is not a portion of the seed layers 104. In some embodiments, other known amorphous materials are substituted for the lower (CoFe)₈₀B₂₀ layer 108.

Further, in at least some embodiments, the seed layers 104 include a manganese nitride (MnₓN) layer 110 that is formed to extend over the lower (CoFe)₈₀B₂₀ layer 108, and to extend in the vertical direction, at approximately room temperature. In some embodiments, x (the number of Mn atoms) generally has a value within a range of approximately 2 to approximately 4.5. In some embodiments, x generally has a value of at least 2 and not more than 4.0. In some embodiments, the MnₓN is deposited by reactive sputtering from a Mn target with a sputter gas containing an Ar-N₂ mixture with the Ar-to-N₂ ratio of approximately 85:15. In some embodiments, the MnₓN layer 110 has a thickness of approximately 50 Å to approximately 300 Å. In some embodiments the MnₓN layer 110 is formed with the desired Miller indices directional value of (001) for the orientation, i.e., the planes of the atoms in the crystalline structure are oriented to form successive layers of atoms that sequentially extend in the vertical direction (see FIG. 1).

The MnₓN layer 110 facilitates forming, i.e., depositing, a CsCl-like chemical templating layer (CTL), or more specifically, a binary alloy with CsCl structure as represented by A₁₋ₓEₓ, where A is a transition metal element and E is a main group element. In some embodiments, A is cobalt (Co) and E includes at least one other element that includes aluminum (Al), with x being in a range from 0.45 to 0.55. Therefore, at least one strongly-textured crystalline cobalt-aluminum (CoAl) layer, i.e., a first CoAl layer 112, as discussed further herein, above the MnₓN layer 110, thereby defining a (001) texture of the CoAl. The amorphous lower (CoFe)₈₀B₂₀ layer 108 facilitates breaking any texture of the underlying layers, i.e., the MnₓN layer 110 grows over the (CoFe)₈₀B₂₀ layer 108 with the (001) orientation, thereby facilitating directional and texture values of (001) in the layers above the MnₓN layer 110. While it is important that the (CoFe)₈₀B₂₀ be amorphous, the composition of the (CoFe)₈₀B₂₀ is not critical, i.e., the Co-to-Fe ratio is not restricted to any particular range of values. Moreover, the B content of this amorphous CoFeB alloy may be varied. Accordingly, the MnₓN layer 110 is employed for promoting ordered growth of the CoAl layer 112, and other layers above, where the ordered CoAl layer 112 has alternating planes of cobalt atoms and aluminum atoms.

In one or more embodiments, the seed layers 104 include the CoAl layer 112 that is formed to extend over MnₓN layer 110, and to extend in the vertical direction, and deposited at approximately room temperature. In some embodiments, the thickness of the CoAl layer 112 is within a range between approximately 20 Å to approximately 400 Å, and in some embodiments, has a thickness of approximately 150 Å.

In embodiments according to the present invention, a non-magnetic platinum-aluminum (PtAl) layer 114 is formed to extend over the CoAl layer 112, and extend in the vertical direction. The PtAl layer 114 also has a crystalline structure, i.e., a CsCl-like structure, and is epitaxially grown over the CoAl layer 112 at approximately room temperature within an argon (Ar) deposition pressure range of, and without limitation, approximately 0.5 milli Torr (mTorr) and approximately 5 mTorr. In some embodiments, the out-of-plane lattice constant is strongly correlated to the Ar deposition pressures. In some embodiments, the composition of the PtAl layer 114 has a CsCl-like structure selected from the platinum-aluminum group consisting of PtₓAl₁₋ₓ, where 0.4 < x < 0.6. In some embodiments, the target composition of the PtAl layer 114 is a ratio of approximately 32:68 (platinum-to-aluminum). The PtAl layer 114 is subsequently annealed at temperatures within the range between approximately 100°C to approximately 400°C, and in some embodiments, at approximately 340°C. In some embodiments, the thickness of the PtAl layer 114 is in the range from approximately 50 Å to approximately 400 Å, and in some embodiments, has a thickness of approximately 300 Å. In some embodiments, the PtAl layer 114 is referred to as the spin orbit torque (SOT) layer 114.

The PtAl layer 114 at least partially defines a templating structure, i.e., in some embodiments, a templating layer 118 (discussed further herein). The templating layer 118 is not necessarily limited to a single layer structure and in some embodiments is a multilayer structure of CsCl-like chemical templating compounds in addition to the CsCl-like structure of the PtAl layer 114. Therefore, in some embodiments, the templating layer 118 is referred to as the templating structure 118. In some embodiments, such multilayer structure of CsCl-like chemical templating compounds includes, without limitation, CoAl, CoGa, CoGe, IrAl, RuAl, and the like. Therefore, in some embodiments according to the present invention, the templating layer 118 includes at least one layer of PtAl and at least one layer of another material, or materials, with a CsCl-like structure. The lattice constant of PtAl is approximately 3.04Å, which is close to that for CoAl (approximately 2.86Å ) or IrAl (approximately 2.98Å), such that the Heusler compound will be formed with a strain similar to that as would be templated by CoAl and IrAl. Notably, regardless of the configuration of the templating layer 118, the PtAl layer 114 should be proximate to the Mn₃Ge layer 120. In some embodiments, the PtAl layers is directly coupled to the Mn₃Ge layer 120.

The PtAl layer 114 is a binary alloy of a heavy metal, such as Pt, with the main group element being Al, to form an alternating layered structure, where the PtAl layer 114 forms an alternating layer structure similar to that of CoAl, IrAl, and RuAl that is configured to template, i.e., promote growth of the ordered Heusler compound at relatively low temperatures. This alternating layer growth is formed at substantially all of the Ar deposition pressures described herein. The previously described annealing of the PtAl layer 114 facilitates inducing the PMA in the Heusler material (as discussed further herein). In at least some embodiments, the PtAl layer 114 promotes ordered growth in the Heusler compounds that include, without limitation, Heusler compounds such as Mn₃Z, where Z = Ga, Ge, Sn or Sb (further details are provided herein). Accordingly, the templating layer 118, i.e., the PtAl layer 114 promotes growth of the ultrathin Heusler compound of the Mn₃Ge layer 120 in contact with the PtAl layer 114. These effects are discussed further herein.

In addition, the PtAl layer 114 facilitates a reduction in the switching current of the MTJ 122 in the MRAM stack 100 that is achieved through assisting the spin transfer torque (STT) with a simultaneous contribution from the spin orbit torque (SOT) through leveraging the spin Hall effect via the PtAl layer 114. The PtAl layer 114 generates the necessary spin orbit torque through the spin Hall contribution to facilitate the compounding with the spin transfer torque to switch the magnetization orientation of the Heusler compound placed in contact with PtAl layer 114. The generation of spin orbit torque is at least partially dependent on the use of layers containing heavy metal in close proximity of the free layer. These effects are discussed further herein. As described further herein, the PtAl layer 114 is configured to receive and transmit an in-plane current to exercise the spin Hall effect to facilitate inducing the spin orbit torque.

In one or more embodiments, the seed layers 104 define a crystalline structure thereof that is employed to template a manganese-germanium layer, i.e., a Mn₃Ge layer 120, where the Mn₃Ge layer 120 is a crystalline Heusler compound (or alloy). The Heusler compound Mn₃Ge is described in its stoichiometric form here; however, it is possible to vary the stoichiometry over a limited range as described for some embodiments further herein. In some embodiments, the templating is executed through epitaxially growing the Mn₃Ge layer 120. The Mn₃Ge layer 120 is sometimes referred to as the "Heusler layer" (shown as 220 in FIG, 2). In addition, the Mn₃Ge layer 120 is sometimes referred to as the lower magnetic layer of a magnetic tunneling junction (MTJ) 122. Moreover, the Mn₃Ge layer 120 is sometimes referred to as the "free layer." Furthermore, the Mn₃Ge layer 120 is sometimes referred to as the "switchable magnetic layer." In addition, the Mn₃Ge layer 120 is sometimes referred to as the "storage layer."

In general, the Mn₃Ge layer 120 is a magnetic intermetallic substance that has a tetragonal crystal configuration, a relatively large volume perpendicular magnetic anisotropy (PMA), and a low magnetic moment (not shown in FIG. 1) that requires lower switching currents. The Mn₃Ge layer 120 is configured to drive current through the MTJ 122 in a current-perpendicular-to-plane (CPP) direction. In some embodiments, the thickness of the ultrathin Mn₃Ge layer 120 is less than approximately 5 nanometers (nm), i.e., less than approximately 50 Å. In some embodiments, the thickness of the Mn₃Ge layer 120 is at least approximately 1 nm thick, i.e., approximately 10 Å. In some embodiments, the thickness of the Mn₃Ge layer 120 is within a range of approximately 13 Å and approximately 21 Å. In some embodiments, the Mn₃Ge layer 120 is approximately 15 Å. In some embodiments, the Heusler layer 120 may be a multilayer object that includes one or more Heusler compounds and/or other materials. In some embodiments, the Mn₃Ge layer 120 is templated at approximately room temperature by the templating layer 118 which includes the PtAl layer 114 and then subsequently annealed at temperatures within the range between approximately 100°C to approximately 400°C, and in some embodiments, at approximately 340°C.

While the one embodiment described above includes the use of Mn₃Ge as the selected Heusler compound, there are a number of alternative Heusler compounds as well. In general, tetragonal Heusler compounds include Mn₃Z, where Z= germanium (Ge), tin (Sn), and antimony (Sb), since they all have the relatively large volume PMA, and have a low magnetic moment. In some embodiments the composition is selected from Mn_{3.3-x}Ge, Mn_{3.3- x}Sn, and Mn_{3.3-x}S_{b}, with x being in a range from 0 to not more than 1.1. In some embodiments, the Heusler compound is a ternary Heusler compound, e.g., selected from the manganese-cobalt-tin group including one of Mn_{3.3- x}Co_{1.1-y}Sn, in which x ≤ 1.2 and y ≤ 1.0. Moreover, in some embodiments, the Heusler compound is chosen from Mn₃Al, Mn₃Ga, Mn₃In, Mn₂FeSb, Mn₂CoGe, Mn₂CoSi, Mn₂CuSi, Mn₂CoSn, Co₂CrAl, Co₂CrSi, Co₂MnSb, and Co₂MnSi. Further discussion on the use of Heusler compounds herein will be limited to Mn₃Ge.

In some embodiments, the MTJ 122 includes an optional polarization enhancement layer 124 (shown as 224 in FIG. 2) that is configured to enhance the polarization of the different spin-polarized currents to further enhance the TMR of the MTJ 122. The materials of the polarization enhancement layer 124 have one or more high spin polarization features where the materials include, without limitation, one or more of Fe, CoFe, and (CoFe)₈₀B₂₀. As shown in FIG. 1, in some embodiments, the polarization enhancement layer 124 is positioned between the Mn₃Ge layer 120 and a MgO layer 126 (discussed further herein). In some embodiments, the polarization enhancement layer 124 is positioned between the MgO layer 126 and an upper (CoFe)₈₀B₂₀ layer 128 (discussed further herein). In some embodiments, the polarization enhancement layer 124 is positioned on both sides of the MgO layer 126.

In at least some embodiments, the MTJ 122 includes the MgO layer 126, that is also referred to as the tunnel barrier 126 (shown as 226 in FIG. 2), formed from crystalline MgO. In some embodiments, the MgO layer 126 is in direct contact with the Mn₃Ge layer 120 (lower magnetic layer) and the upper (CoFe)₈₀B₂₀ layer 128 (upper magnetic layer). Therefore, in such embodiments, the tunnel barrier 126 is thereby positioned between, and in contact with, the first magnetic layer (i.e., the Mn₃Ge layer 120, or the lower magnetic layer) and the second magnetic layer (i.e., the upper (CoFe)₈₀B₂₀ layer 128, or the upper magnetic layer). In some embodiments, the MgO layer 126 is separated from one of the Mn₃Ge layer 120 and the upper (CoFe)₈₀B₂₀ layer 128 through the optional polarization enhancement layer 224. The resistance of the MTJ 122 across the MgO layer 126 is high if the magnetic moments of the Mn₃Ge layer 120 and the upper (CoFe)₈₀B₂₀ layer 128 are anti-parallel and low if such magnetic moments are parallel. In some embodiments, the MgO layer 126 is formed to extend directly over the Mn₃Ge layer 120 in the vertical direction at approximately room temperature and in some embodiments, there is an optional polarization enhancement layer 124 therebetween (as shown in FIG. 1). The thickness of the MgO layer 126 determines the RA of the MTJ 122 and is typically in the range from approximately 10 Å to approximately 20 Å. In some embodiments, the thickness of the MgO layer 126 is approximately 13 Å.

In one or more embodiments, the tunnel barrier 126 is formed from MgAl₂O₄ where the lattice spacing is tuned (engineered) by controlling the Mg-Al composition to result in better lattice matching with the Heusler compounds (as listed above), e.g., and without limitation, the composition of this tunnel barrier 126 can be represented as Mg_{1-z}Al_{2+(2/3)z}O₄, where -0.5 < z < 0.5.

In at least some embodiments, the MTJ 122 includes the upper (CoFe)₈₀B₂₀ layer 128 (shown as 228 in FIG. 2) that is formed to extend over the tunnel barrier 126, and to extend in the vertical direction, at approximately room temperature. In some embodiments, the optional polarization enhancement layer 124 is positioned between the upper (CoFe)₈₀B₂₀ layer 128 and the tunnel barrier 126. In some embodiments, the upper (CoFe)₈₀B₂₀ layer 128 has a thickness in a range from approximately 12 Å to 16 Å, and in some embodiments, with a value of approximately 14 Å. In some embodiments, the upper (CoFe)₈₀B₂₀ layer 128 is a reference layer that defines a reference layer magnetic moment (not shown in FIG. 1). The magnetic moment of the upper (CoFe)₈₀B₂₀ layer 128 is generally fixed, or pinned, in a particular direction perpendicular-to-plane. Moreover, in some embodiments, the upper (CoFe)₈₀B₂₀ layer 128 includes a bilayer of CoFeB compounds for different B content which ranges between approximately 15 to approximately 35%. Therefore, the upper (CoFe)₈₀B₂₀ layer 128 is sometimes referred to as the upper magnetic layer.

In some embodiments, the MRAM stack 100 includes an upper Ta layer 130 with a thickness of approximately 2.5 Å to approximately 50 Å that is formed to extend over the upper (CoFe)₈₀B₂₀ layer 128, and to extend in the vertical direction, at approximately room temperature. In some embodiments, the upper (CoFe)₈₀B₂₀ layer 128 is annealed at approximately 340°C.

In some embodiments, the MRAM stack 100 includes an optional synthetic anti-ferromagnet (SAF) tri-layer 132 (shown as 232 in FIG. 2) positioned to extend over the upper Ta layer 130. In such embodiments, the Ta thickness is chosen to provide optimal magnetic coupling between the SAF tri-layer 132 and the upper (CoFe)₈₀B₂₀ layer 128. The SAF tri-layer 132 includes a lower cobalt/platinum (Co/Pt) layer 134 that includes three sequential bi-layers of approximately 2.7 Å of Co and approximately 6 Å of Pt, and a single layer of Co that is approximately 5 Å thick. The SAF tri-layer 132 also includes a Ru layer 136 on top of the Co/Pt layer 134 that is approximately 9 Å thick. The SAF tri-layer 132 further includes an upper Co/Pt layer 138 on top of the Ru layer 136 that includes a single layer of Co that is approximately 5 Å thick and also includes four sequential bi-layers of approximately 2.7 Å of Co and approximately 6 Å of Pt. The SAF tri-layer 132 facilitates stabilizing the magnetic moment of the upper (CoFe)₈₀B₂₀ layer 128 (i.e., the reference electrode) to a high magnetic field thus making the coercivity of the upper (CoFe)₈₀B₂₀ layer 128 significantly higher than the coercivity of the Mn₃Ge layer 120 (the lower, switchable magnetic layer).

In one or more embodiments, the MRAM stack 100 includes a cap layer 140 (shown as 240 in FIG. 2) that is formed from either Ru or a combination of Pt and Ru to extend over either the upper Ta layer 130 or the SAF tri-layer 132 in the vertical direction at approximately room temperature. In some embodiments, the cap layer 140 is formed from approximately 100 Å of Ru. Also, in some embodiments, the cap layer 140 includes one of, or compounds of more than one of, Mo, W, Ta, and Ru.

Referring to FIG. 2, the magnetic layer 228 (shown as the upper (CoFe)₈₀B₂₀ layer 128 in FIG. 1) is shown with the respective magnetic moment 250. The spin transfer torque (STT) effect facilitates the switching of the MTJ 222 (shown as 122 in FIG. 1). More specifically, the magnetic moment 250 of the magnetic layer 228 (also referred to as the upper reference layer and the upper (CoFe)₈₀B₂₀ layer 128 (see FIG. 1)) is generally fixed, or pinned, in a particular direction. The magnetic layer 228 has a perpendicular magnetic anisotropy (PMA) energy that exceeds the out-of-plane demagnetization energy. Consequently, the magnetic moment 250 is shown as perpendicular to plane. The magnetic moment 250 of the reference layer 228 is stable in the embodiment shown. Therefore, the magnetic moment 250 is shown as a single-headed arrow. Although shown in a particular direction (toward the top of the page), the magnetic moment 250 may be stable in another direction (e.g., toward the bottom of the page).

The lower free layer, i.e., the Heusler layer 220 (also referred to as the Mn₃Ge layer 120 in FIG. 1 (the lower, switchable magnetic layer)) has a changeable magnetic moment 260. In the embodiment shown, the Heusler layer 220 also has a PMA energy that exceeds the out-of-plane demagnetization energy. Consequently, the magnetic moment 260 is shown as perpendicular to plane. The magnetic moment 260 is programmed to be in one of multiple stable states. Therefore, the magnetic moment 260 is shown as dual-headed arrow. The Heusler layer 220 is used to store information with the data state of either a "1" or a "0," therefore the Heusler layer 220 is sometimes referred to as "the storage layer."

The electrons that define an electric current have the intrinsic quantum mechanics property of spin that is associated with the spin angular momentum of the electrons. To take advantage of the STT effect the electron spin will have one of two distinct quantum states, i.e., spin-up and spin-down. In general, an electric current is unpolarized, i.e., consisting of approximately 50% spin-up electrons and approximately 50% spin-down electrons. A spin-polarized current is one with more electrons of either spin state. The electrical conductivity features of the MRAM stack 200 above and below the MTJ 222 are used to drive current through the MTJ 222 in a current-perpendicular-to-plane (CPP) direction. Therefore, such MTJs 222 having PMA are advantageous as they require smaller switching currents as compared to in-plane magnetized MTJs.

By passing a current, e.g., current 270 from the substrate 202 through the cap layer 240 and, therefore, through the fixed magnetic layer 228, a spin-polarized current 272 is produced, where the spin-polarization is in the direction of the magnetic moment 250, and where the spin-polarized current 272 has a polarized spin angular momentum. Note that, by convention, the electron flow direction is opposite to the current direction. When this spin-polarized current 272 is directed into the Heusler layer 220, the polarized spin angular momentum is transferred to the Heusler layer 220 such that both magnetic layers, i.e., the fixed magnetic layer 228 and the Heusler layer 220 have the same orientation of the magnetic moment. As such, a spin transfer torque (STT) (not shown) is applied to the Heusler layer 220 thereby potentially changing its magnetization direction from anti-parallel state to the parallel state if the current flow exceeds the threshold value, i.e., potentially flipping the orientation of the respective magnetic field, i.e., the magnetic moment 260. Flipping the orientation of the magnetic moment 260 from one direction of the arrow 260 to the opposite direction will flip the data state of the Heusler layer 220, sometimes referred to "toggling the Heusler layer upward." In the present case, the resulting orientation of the magnetic moment 260 of the Heusler layer 220 will be upward, i.e., parallel to that of the fixed magnetic moment 250, thereby defining a low resistance to current flow in the Heusler layer 220.

The direction of the current flow through the MRAM stack 200 is typically reversible, e.g., as shown by current 280. By passing the current 280 from the cap layer 240 towards the substrate 202 and, therefore, through the fixed magnetic layer 228, a spin-polarized current 282 is produced, where the spin-polarization is opposite to the direction of the magnetic moment 250, and where the spin-polarized current 282 has a polarized spin angular momentum opposite to that for the spin-polarized current 272. When this spin-polarized current 282 is directed into the Heusler layer 220, the polarized spin angular momentum is transferred to the Heusler layer 220, both magnetic layers, i.e., the fixed magnetic layer 228 and the Heusler layer 220 have opposite orientation of the magnetic moment. As such, a STT is applied to the Heusler layer 220 thereby potentially changing its magnetization direction from the parallel state to the anti-parallel state if the current flow exceeds the threshold value, i.e., potentially flipping the orientation of the respective magnetic field, i.e., the magnetic moment 260. Flipping the orientation of the magnetic moment 260 from one direction of the arrow 260 to the opposite direction will flip the data state of the Heusler layer 220, sometimes referred to "toggling the Heusler layer downward." In the present case, the resulting orientation of the magnetic moment 260 of the will be downward, i.e., anti-parallel to that of the fixed magnetic moment 250, thereby defining a high resistance to current flow in the Heusler layer 220. Accordingly, different current directions define different spin-polarized currents to generate different magnetic configurations corresponding to different resistances and thus different logical states, e.g., a logical "0" and a logical "1" of the MTJ 222.

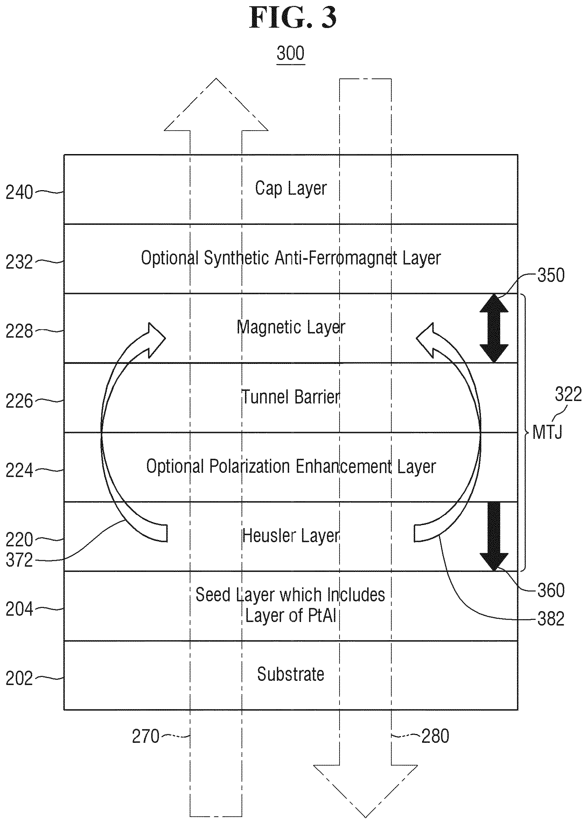

Referring to FIG. 3, a simplified block schematic diagram is presented illustrating portions of the MRAM stack 300 (shown as the MRAM stack 100 and 200 in FIGs. 1 and 2, respectively) and the respective magnetic moments, in accordance with some embodiments of the present disclosure. Similar components in FIGs. 1, 2, and 3 have similar numbering, and the unaffected components of FIG. 3 retain the numbering from FIG. 2.

In at least some embodiments, the MRAM stack 300 of FIG. 3 differs from the MRAM stack 200 of FIG. 2 in that the MTJ 322 is modified. Specifically, the Heusler layer 320 is the set reference layer with the set magnetic moment 360 and the magnetic layer 328 is the switchable magnetic layer with the switchable magnetic moment 350, and therefore, the magnetic layer 328 assumes the role of the storage layer. As such, the directions of the spin-polarized current 372 and the spin-polarized current 382 are reversed from their counterparts of spin-polarized current 272 and the spin-polarized current 282, respectively, from FIG. 2. Otherwise, the operation of the MRAM stack 300 is substantially similar to that for the MRAM stack 200 (see FIG. 2) subject to the reversal of the roles of the magnetic layer 228/328 and the Heusler layer 220/320 as indicated through the directions of the arrows for magnetic moments 350 and 360 in comparison with the magnetic moments 250 and 260, respectively.

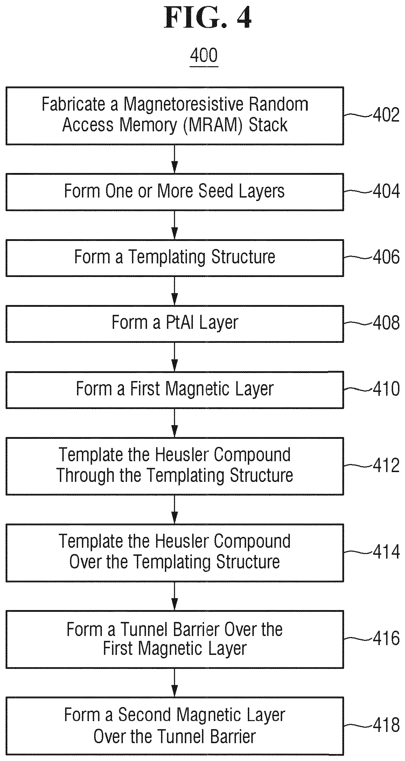

Referring to FIG. 4, a flowchart is presented illustrating a process 400 for fabricating 402 a MRAM stack 100 (see FIG. 1), in accordance with some embodiments of the present invention. Also referring to FIG. 1, one or more seed layers 104 are formed 404, including forming 406 a templating structure 118 that is not necessarily limited to a single layer structure and in some embodiments is a multilayer structure of CsCl-like chemical templating compounds, including a crystalline structure. In some embodiments, the forming 406 the templating structure 118 includes positioning the templating structure 118 above the substrate 102. The forming step 406 includes forming 408 a layer 114 of a binary alloy including platinum-aluminum (PtAl). The PtAl layer 114 provides the effects and benefits as described elsewhere herein.

In at least some embodiments, the process 400 for fabricating 402 a MRAM stack 100 also includes forming 410 the first magnetic layer 120. Forming 410 the first magnetic layer 120 includes templating 412 a Heusler compound through the templating structure 118. The Heusler compound has a perpendicular magnetic anisotropy (PMA) energy exceeding an out-of-plane demagnetization energy. Moreover, the forming 410 the first magnetic layer 120 further includes templating 414 the Heusler compound over the templating structure.

The process 400 for fabricating 402 a MRAM stack 100 further includes forming 416 a tunnel barrier 126 over the first magnetic layer 120, and forming 418 a second magnetic layer 128 over the tunnel barrier 126, thereby positioning the tunnel barrier 126 between, and in contact with, the first magnetic layer 120 and the second magnetic layer 128. Additional details of the fabrication process 400 are presented in the discussion of the individual layers of the MRAM stack 100 with respect to FIG. 1.

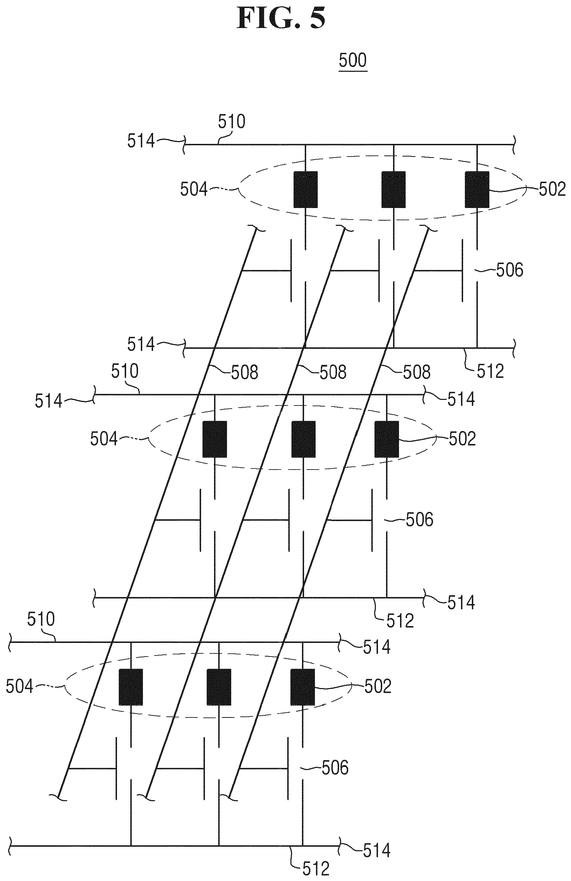

Referring to FIG. 5, a block schematic diagram is presented illustrating a MRAM array 500, in accordance with some embodiments of the present disclosure. Specifically, FIG. 5 presents an array 500 of MRAM cells 502, where only three of the nine shown MRAM cells 502 are labeled for clarity. In some embodiments, the plurality of MRAM cells 502 are arranged in respective cell locations 504. In some embodiments, each MRAM cell 502 includes one or more MRAM stacks 100 (see FIG. 1). Each MRAM cell 502 is connected to a respective transistor 506 that controls reading and writing, where only three of the nine shown transistors 506 are labeled for clarity. In one or more embodiments, a word line 508 provides data to write to the MRAM cells 502, while a bit line 510 and a complementary bit line 512 read data from the MRAM cell 502. In this manner, a large array 500 of MRAM cells 502 can be implemented on a single chip (not shown). An arbitrarily large number of MRAM cells 502 can be employed, within the limits of the manufacturing processes and design specifications. In some embodiments, read operations and write operations use different transistors 506 and word lines 508.

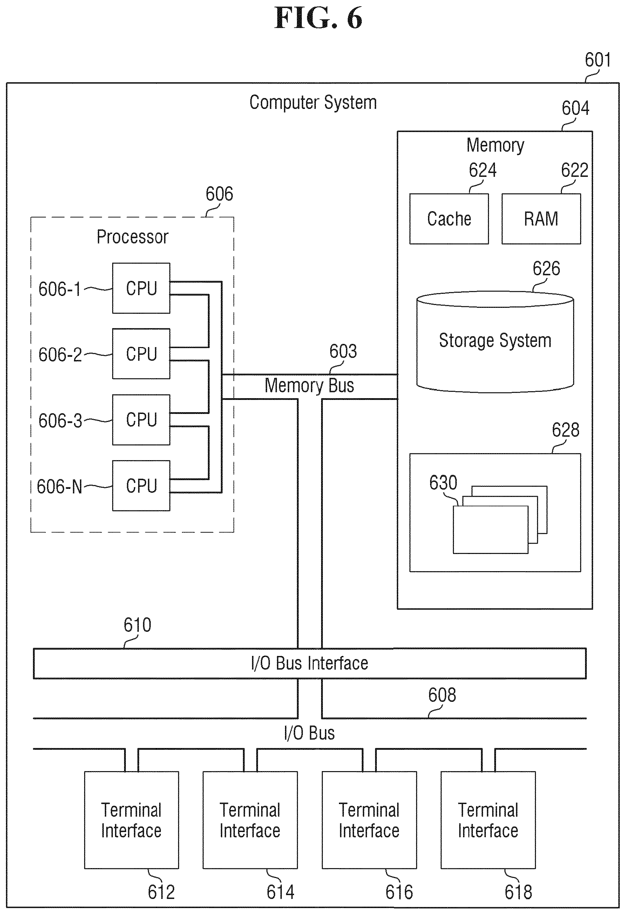

In some embodiments, the operation of the MRAM array 500 includes writing data to a MRAM cell 502 includes passing a current (not shown) through the MRAM cell 502. This current causes the direction of magnetization to switch between a parallel or anti-parallel state, which has the effect of switching between low resistance and high resistance states. Because this effect can be used to represent the subsets of ones and zeroes of digital information, the MRAM cells 502 can be used as a non-volatile memory (see FIG. 6).

Also, referring to FIGs. 1, 2, and 3, passing the current in one direction through the MRAM cell 502 causes the magnetization of the free layer 120/220/320 to be parallel with that of the reference layer 128/228/328, while passing the current in the opposite direction through the MRAM cell 502 causes the magnetization of the free layer 120/220/320 to be anti-parallel to that of the reference layer 128/228/328. Reading the bit stored in a MRAM cell 502 involves applying a voltage (lower than that used for writing information) to the MRAM cell 502 to discover whether the cell offers high resistance to current ("1") or low resistance ("0").

In at least some embodiments, the plurality of bit lines 510 and a plurality of complementary bit lines 512 defines a plurality of bit line-complementary bit line pairs 514. A plurality of word lines 508 intersect the plurality of bit line pairs 514 at a plurality of cell locations 504. The plurality of MRAM cells 502 are located at one of each of the plurality of cell locations 504. Each of the MRAM cells 502 is electrically connected to a corresponding bit line 510 and selectively interconnected to a corresponding one of the complementary bit lines 512 under control of a corresponding one of the word lines 508. In some embodiments, e.g., without limitation, a respective transistor 506 is a field effect transistor turned off or on by a signal from the respective word line 508 applied to its gate, which controls reading and writing and whether the cell is coupled to the complementary bit lines 512. In some embodiments, separate transistors 506 are used for read and write operations. Accordingly, each word line 508 of the plurality of word lines 508 is configured to receive one or more signals to cause a first subset of the plurality of MRAM cells 502 to store logical ones and a second subset of the plurality of cells to store logical zeroes. Also, accordingly, each bit line-complementary bit line pair 514 of the plurality of bit line-complementary bit line pairs 514 is configured to read the stored logical ones and stored logical zeroes resident within the respective subsets.

Referring now to FIG. 6, a block schematic diagram is provided illustrating a computing system 601 that may be used in implementing one or more of the methods, tools, and modules, and any related functions, described herein (e.g., using one or more processor circuits or computer processors of the computer), in accordance with some embodiments of the present disclosure. In some embodiments, the major components of the computer system 601 may comprise one or more CPUs 602, a memory subsystem 604, a terminal interface 612, a storage interface 616, an I/O (Input/Output) device interface 614, and a network interface 618, all of which may be communicatively coupled, directly or indirectly, for inter-component communication via a memory bus 603, an I/O bus 608, and an I/O bus interface unit 610.

The computer system 601 may contain one or more general-purpose programmable central processing units (CPUs) 602-1, 602-2, 602-3, 602-N, herein collectively referred to as the CPU 602. In some embodiments, the computer system 601 may contain multiple processors typical of a relatively large system; however, in other embodiments the computer system 601 may alternatively be a single CPU system. Each CPU 602 may execute instructions stored in the memory subsystem 604 and may include one or more levels of on-board cache.

System memory 604 may include computer system readable media in the form of volatile memory, such as random access memory (RAM) 622 or cache memory 624. Computer system 601 may further include other removable/non-removable, volatile/non-volatile computer system storage media. By way of example only, storage system 626 can be provided for reading from and writing to a non-removable, non-volatile magnetic media, such as a "hard drive." Although not shown, a magnetic disk drive for reading from and writing to a removable, non-volatile magnetic disk (e.g., a "floppy disk"), or an optical disk drive for reading from or writing to a removable, non-volatile optical disc such as a CD-ROM, DVD-ROM or other optical media can be provided. In addition, memory 604 can include flash memory, e.g., a flash memory stick drive or a flash drive. Moreover, the non-volatile SOT-MRAM devices as described herein are included as a portion of the described suite of memory devices. Memory devices can be connected to memory bus 603 by one or more data media interfaces. The memory 604 may include at least one program product having a set (e.g., at least one) of program modules that are configured to carry out the functions of various embodiments.

Although the memory bus 603 is shown in FIG. 6 as a single bus structure providing a direct communication path among the CPUs 602, the memory subsystem 604, and the I/O bus interface 610, the memory bus 603 may, in some embodiments, include multiple different buses or communication paths, which may be arranged in any of various forms, such as point-to-point links in hierarchical, star or web configurations, multiple hierarchical buses, parallel and redundant paths, or any other appropriate type of configuration. Furthermore, while the I/O bus interface 610 and the I/O bus 608 are shown as single respective units, the computer system 601 may, in some embodiments, contain multiple I/O bus interface units 610, multiple I/O buses 608, or both. Further, while multiple I/O interface units are shown, which separate the I/O bus 608 from various communications paths running to the various I/O devices, in other embodiments some or all of the I/O devices may be connected directly to one or more system I/O buses.

In some embodiments, the computer system 601 may be a multi-user mainframe computer system, a single-user system, or a server computer or similar device that has little or no direct user interface, but receives requests from other computer systems (clients). Further, in some embodiments, the computer system 601 may be implemented as a desktop computer, portable computer, laptop or notebook computer, tablet computer, pocket computer, telephone, smart phone, network switches or routers, or any other appropriate type of electronic device.

It is noted that FIG. 6 is intended to depict the representative major components of an exemplary computer system 601. In some embodiments, however, individual components may have greater or lesser complexity than as represented in FIG. 6, components other than or in addition to those shown in FIG. 6 may be present, and the number, type, and configuration of such components may vary.

One or more programs/utilities 628, each having at least one set of program modules 630 may be stored in memory 604. The programs/utilities 628 may include a hypervisor (also referred to as a virtual machine monitor), one or more operating systems, one or more application programs, other program modules, and program data. Each of the operating systems, one or more application programs, other program modules, and program data or some combination thereof, may include an implementation of a networking environment. Programs 628 and/or program modules 630 generally perform the functions or methodologies of various embodiments.

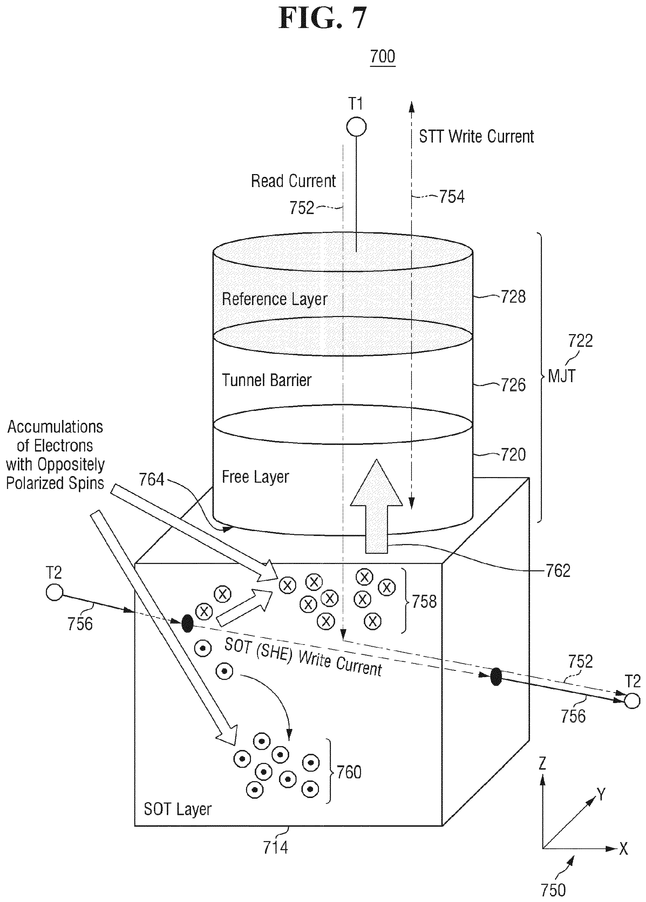

Referring to FIG. 7, a block schematic diagram is presented illustrating a three-terminal SOT-MRAM device 700, in accordance with some embodiments of the present disclosure. Also referring to FIGs. 1 and 2, the three-terminal SOT-MRAM device 700 is similar to the MRAM stacks 100 and 200. Accordingly, the three-terminal SOT-MRAM device 700 is an SOT-enhanced STT-MRAM stack as described herein. In some embodiments, a plurality of the SOT-enhanced STT-MRAM stacks are embedded in larger three-terminal MRAM devices such as, and without limitation, the MRAM cells 502 in the MRAM array 500 and the memory 604 (shown in FIGs. 5 and 6, respectively).

A set of axes 750 for the three orthogonal dimensions of X, Y and Z is provided in FIG. 7 for reference. The three-terminal SOT-MRAM device 700 includes a MTJ 722 that is substantially similar to the MTJs 122 and 222. Specifically, the three-terminal SOT-MRAM device 700 includes a reference layer 728, a tunnel barrier 726, a free layer 720, and a spin orbit torque (SOT) layer 714 that are substantially similar to those components similarly labeled in FIGs. 1 and 2. In addition, the three-terminal SOT-MRAM device 700 includes a first terminal T1 electrically coupled to the reference layer 728, and a second terminal T2 and a third terminal T3 electrically coupled to the SOT layer 714. Therefore, the MRAM array 500 is substantially compatible with the three-terminal SOT-MRAM device 700, where the MRAM array 500 would require at least additional transistors 506 to accommodate both read and write functionality. In some embodiments, the T1 terminal is electrically coupled to a read transistor 506, the T2 terminal is electrically coupled to a write transistor 506, and the terminal T3 is electrically coupled to a bit line 510 (see FIG. 5). In some embodiments, the terminals T1, T2, and T3 are electrically coupled to any devices that enable operation of the three-terminal SOT-MRAM device 700 as described herein.

In at least some embodiments, a read current 752 is transmitted through terminal T1 through the MTJ 722 into the SOT layer 714 to terminal T3 to implement read operations of the data state stored in the free layer 720. Also, an STT write current 754 is used through the MTJ 722 to implement write operations to change the data state in the free layer 720. To enhance the write operations of the three-terminal SOT-MRAM device 700, an SOT (SHE) (spin Hall effect) write current 756 is simultaneously transmitted from the terminal T2 along the X-axis through the SOT layer 714 into the terminal T3. The SOT layer 714 has a high spin orbit coupling that facilitates employment of the spin Hall effect resulting in accumulations of electrons with oppositely polarized spins 758 and 760 at the walls of the SOT layer 714 opposing each other across the Z-axis. These polarized-spin electrons 758 and 760 induce an injected spin current 762 into the free layer 720 parallel to the Z-axis to further induce a spin orbit torque into the free layer 720 to enhance the toggling of the magnetic moment 260 thereof (as described with respect to FIG. 2).

The transverse SOT spin-polarized current 762 across a free layer 720-to-SOT layer 714 interface 764 is generated by injecting the in-plane SOT write electrical current 756 in the adjacent SOT layer 714. This effect is unlike the STT-MRAM where the STT write electrical current 754 is injected perpendicularly into the magnetic tunnel junction 722 and the read and write operation is performed through the same path. Specifically, compared to the STT writing alone, SOT writing is decoupled from TMR-based STT reading using 3 terminal geometry, which allows larger cell endurance. The SOT effect converts charge into spin current, perpendicular to the free layer 720, which enables ultra-fast switching of the three-terminal MRAM device 700. In addition, the separation between reading and writing paths allows higher currents to be applied for writing, where each path can be optimized independently. In addition, STT-MRAM has several limitations resulting from sharing the read and write path, including potential degradation of the tunnel barrier 726 from repeated switching. Therefore, spin-orbit torque (SOT) switching overcomes such limitations of STT by partial decoupling of the write current path from the MTJ tunnel barrier 726.

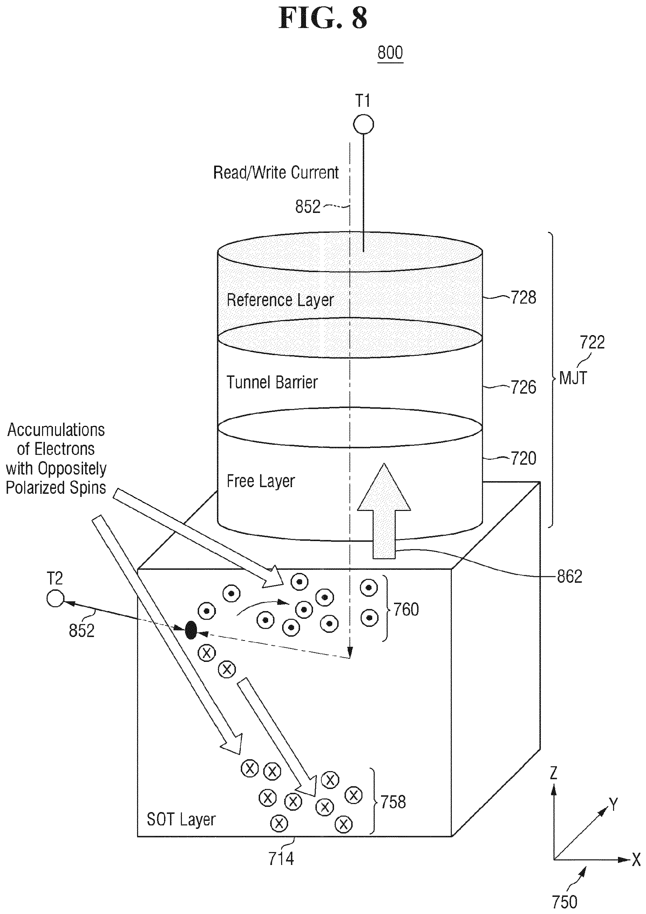

Referring to FIG. 8, a block schematic diagram is presented illustrating a two-terminal SOT-MRAM device 800, in accordance with some embodiments of the present disclosure. The two-terminal SOT-MRAM device 800 shares similar components with the three-terminal SOT-MRAM device 700 (see FIG. 7) and therefore shares similar numbering for such components. There is no terminal T3, the terminal T1 is electrically coupled to a bit line 510, and the terminal T2 is electrically coupled to a word line 508 (see FIG. 5). Both read and write currents 852 are injected into the MTJ 722 through terminal T1. The read/write current 852 is further transmitted into the SOT layer 714 parallel to the Z-axis and then terminal T2. The read/write current 852 is diverted from the perpendicular-to-plane direction through the MTJ 722 to an in-plane direction within the SOT layer 714. The SOT layer 714 has a high spin orbit coupling that facilitates employment of the spin Hall effect resulting in accumulations of electrons with oppositely polarized spins 758 and 760 at the walls of the SOT layer 714 opposing each other across the Z-axis. These polarized-spin electrons 758 and 760 induce an injected spin current 862 into the free layer 720 parallel to the Z-axis to further induce a spin orbit torque into the free layer 720 to enhance the toggling of the magnetic moment 260 thereof (as described with respect to FIG. 2). Accordingly, in addition to the three-terminal SOT-MRAM device 700, another possible device configuration is the two-terminal SOT-MRAM device 800 where both STT effects and SOT effects play a role in reducing the overall switching currents which otherwise will be needed in a two-terminal purely STT device. In addition, the two-terminal SOT-MRAM device 800 has a smaller footprint requirement as compared to the three-terminal SOT-MRAM device 700, e.g., and without limitation, the MRAM array 500 is substantially compatible with the two-terminal SOT-MRAM device 800.

Accordingly, the two-terminal SOT-MRAM device 800 is an SOT-enhanced STT-MRAM stack as described herein. In some embodiments, a plurality of the SOT-enhanced STT-MRAM stacks are embedded in larger two-terminal MRAM devices such as, and without limitation, the MRAM cells 502 in the MRAM array 500 and the memory 604 (shown in FIGs. 5 and 6, respectively).

The embodiments as disclosed and described herein are configured to provide an improvement to computer technology. Materials, operable structures, and techniques as disclosed herein can provide substantial beneficial technical effects. Some embodiments may not have all of these potential advantages and these potential advantages are not necessarily required of all embodiments. By way of example only, and without limitation, one or more embodiments may provide enhancements of the value of the tunnel magnetoresistance (TMR) for the respective MRAM stacks through the cooperation of the MnₓN layer 110, the CoAl layer 112, the PtAl (SOT) layer 114, and the free layer 120.

As described above, high TMR is desirable since the higher TMR provides a higher ON/OFF ratio and a greater signal-to-noise ratio of the respective memory cells. At least some of the embodiments described herein are directed toward fabrication enhancements to the memory stacks to enhance the polarization of the electron spin by overcoming the technical limitations present in the state-of-the-art memory stack fabrication processes. Such spin polarization enhancements of the Heusler compound also enhance the associated TMR as well. In some embodiments according to the present invention, the templating layer is PtAl. However, the templating layer is not necessarily limited to a single layer structure and in some examples outside the scope of the present invention is a multilayer structure of CsCl-like chemical templating compounds, such as, and without limitation, CoAl, CoGa, CoGe, IrAl, RuAl, and the like. Accordingly, as disclosed herein in at least some of the embodiments, upward improvements of the TMR of the Heusler compounds are implemented to enhance the performance of the MTJs.

Moreover, an improvement of STT-alone MRAM devices is realized through using SOT effects through the PtAl layer over which the Heusler layer is grown. The use of the spin Hall effect (SHE) to generate a SOT spin current to assist the STT effects to toggle the magnetic moment of the Heusler layer with less read/write current facilitates faster switching with less power draw (as described further herein).

In addition, further improvement of computer technology is achieved through using fabricating multiple MRAM stacks to define a MRAM cell, where a plurality of MRAM cells further define a MRAM array. The MRAM arrays are a used to build a non-volatile MRAM device, and one or more MRAM devices will define a computing system. The overall effect of an extremely large number of MRAM stacks drawing less electrical energy due to their non-volatility (i.e., no power needed to maintain the stored state) will result in a reduction in power consumption of the computer systems.

Moreover, the MRAM stacks described herein facilitate reducing the number of layers in the pillars, thereby reducing the footprint of the respective MRAM devices and the associated costs of fabrication. Notably, a layer of PtAl effectively improves the templating of the free layer, as well as facilitates SHE effects to generate a SOT spin current to cooperate with the existing STT effects.

The present disclosure may be a system, a method, and/or a computer program product at any possible technical detail level of integration. The computer program product may include a computer readable storage medium (or media) having computer readable program instructions thereon for causing a processor to carry out aspects of the present disclosure.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the present disclosure may be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present disclosure are described herein with reference to flowchart illustrations and/or block diagrams of methods, apparatus (systems), and computer program products according to embodiments of the disclosure. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The flowchart and block diagrams in the Figures illustrate the architecture, functionality, and operation of possible implementations of systems, methods, and computer program products according to various embodiments of the present disclosure. In this regard, each block in the flowchart or block diagrams may represent a module, segment, or portion of instructions, which comprises one or more executable instructions for implementing the specified logical function(s). In some alternative implementations, the functions noted in the blocks may occur out of the order noted in the Figures. For example, two blocks shown in succession may, in fact, be accomplished as one step, executed concurrently, substantially concurrently, in a partially or wholly temporally overlapping manner, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

## Claims

1. A magnetic random access memory, MRAM, stack (100, 200, 300) comprising:
a first magnetic layer (120, 220) comprising a Heusler compound; and
one or more seed layers (104, 204) comprising:
a templating structure (118) comprising a crystalline structure configured to template the Heusler compound, wherein the first magnetic layer (120) is formed over the templating structure (118), the templating structure (118) comprising:
a layer of a binary alloy comprising platinum-aluminum, PtAl, the MRAM stack (100, 200, 300) further comprising:
a second magnetic layer (128, 228); and
a tunnel barrier (126, 226) positioned between, and in contact with, one or more of the first magnetic layer (120) and the second magnetic layer (128),
wherein:
the first magnetic layer (120) comprises a storage layer;
the second magnetic layer (128) comprises a reference layer (201, 228); and
the first magnetic layer (120), the tunnel barrier (126, 226), and the second magnetic layer (128) define a magnetic tunnel junction (122, 222), MTJ,
wherein the Heusler compound is chosen from the group consisting of Mn₃Ge, Mn₃Al, Mn₃Ga, Mn₃In, Mn₂FeSb, Mn₂CoGe, Mn₂CoSi, Mn₂CuSi, Mn₂CoSn, Co₂CrAl, Co₂CrSi, Co₂MnSb, and Co₂MnSi, or wherein the Heusler compound is a ternary Heusler compound selected from the manganese-cobalt-tin group consisting of Mn_{3.3-x}Co_{1.1-y}Sn, in which x ≤ 1.2 and y ≤ 1.0, or wherein the first magnetic layer (120, 220) is formed from compounds of Mn₃Z, wherein:
Z is an element selected from the group consisting of germanium, Ge, tin , Sn, and antimony, Sb; and
the compounds of Mn₃Z are selected from the group consisting of Mn_{3.3-x}Ge, Mn_{3.3-x}Sn, and Mn_{3.3-x}Sb, x in a range from 0 to 1.1.

2. The MRAM stack (100, 200, 300) of claim 1, wherein:
the tunnel barrier (126, 226) is formed from compounds selected from the group consisting of MgO and Mg_{1-z}Al_{2+(2/3)z}O₄, wherein -0.5 < z < 0.5.

3. The MRAM stack (100, 200, 300) of claim 1 or 2, wherein the first magnetic layer (120) defines a thickness dimension, and wherein:
the first magnetic layer (120) has a magnetization which is orientated in the thickness dimension; and
the first magnetic layer (120) has a thickness of less than 5 nanometers, nm.

4. The MRAM stack (100, 200, 300) of any one of claims 1 to 3, wherein:
the layer of the binary alloy comprising PtAl has a CsCl-like structure selected from the platinum-aluminum group consisting of PtₓAl₁₋ₓ, in which 0.4 < x < 0.6.

5. A method of fabricating a magnetic random access memory, MRAM, stack (100, 200, 300) comprising:
forming one or more seed layers (104, 204) comprising:
forming a templating structure (118) above a substrate (102, 202), wherein the templating structure (118) includes a crystalline structure, wherein the forming the templating structure (118) comprises:
forming a layer of a binary alloy including platinum-aluminum, PtAl; and
forming a first magnetic layer (120, 220) comprising:
templating a Heusler compound through the templating structure (118),
the method further comprising:
forming a tunnel barrier (126, 226) over the first magnetic layer (120, 220); and
forming a second magnetic layer (128, 228) over the tunnel barrier (126, 226), thereby positioning the tunnel barrier (126, 226) between, and in contact with, the first magnetic layer (120, 220) and the second magnetic layer (128, 228), wherein:
the first magnetic layer (120, 220) defines a storage layer;
the second magnetic layer (128, 228) defines a reference layer (201, 228); and
the first magnetic layer (120, 220), the tunnel barrier (126, 226), and
the second magnetic layer (128, 228) define a magnetic tunnel junction (122, 222), MTJ,
wherein the Heusler compound is chosen from the group consisting of Mn₃Ge, Mn₃Al, Mn₃Ga, Mn₃In, Mn₂FeSb, Mn₂CoGe, Mn₂CoSi, Mn₂CuSi, Mn₂CoSn, Co₂CrAl, Co₂CrSi, Co₂MnSb, and Co₂MnSi, or wherein the Heusler compound is a ternary Heusler compound selected from the manganese-cobalt-tin group consisting of Mn_{3.3-x}Co_{1.1-y}Sn, in which x ≤ 1.2 and y ≤ 1.0, or wherein the first magnetic layer (120, 220) is formed from compounds of Mn₃Z wherein:
Z is an element selected from the group consisting of germanium, Ge, tin ,Sn, and antimony, Sb; and
the compounds of Mn₃Z are selected from the group consisting of Mn_{3.3-x}Ge, Mn_{3.3-x}Sn, and Mn_{3.3-x}Sb, x in a range from 0 to 1.1.

6. The method of claim 5, further comprising:
templating the Heusler compound over the templating structure (118).

7. The method of claim 5 or 6, wherein:
the forming the layer of the binary alloy including the PtAl comprises:
forming a layer of a binary alloy having a CsCl-like structure selected from the platinum-aluminum group consisting of PtₓAl₁₋ₓ, in which 0.4 < x < 0.6.

## Patentansprüche

1. Magnetischer Direktzugriffsspeicher, MRAM,-Stapel (100, 200, 300), aufweisend:
eine erste magnetische Schicht (120, 230), die eine Heusler-Verbindung aufweist; und
eine oder mehrere Keimschichten (104, 204), die Folgendes aufweisen:
eine Vorlagenstruktur (118), die eine Kristallstruktur aufweist, die dazu ausgebildet ist, der Heusler-Verbindung als Vorlage zu dienen, wobei die erste magnetische Schicht (120) über der Vorlagenstruktur (118) ausgebildet ist, wobei die Vorlagenstruktur (118) Folgendes aufweist:
eine Schicht einer binären Legierung, die Platin-Aluminium, PtAl, aufweist,
wobei der MRAM-Stapel (100, 200, 300) ferner Folgendes aufweist:
eine zweite magnetische Schicht (128, 228); und
eine Tunnelbarriere (126, 226), die zwischen und in Kontakt mit mindestens einer von der ersten magnetischen Schicht (120) und der zweiten magnetischen Schicht (128) angeordnet ist, wobei:
die erste magnetische Schicht (120) eine Speicherschicht aufweist;
die zweite magnetische Schicht (128, 228) eine Referenzschicht (201, 228) aufweist; und
die erste magnetische Schicht (120), die Tunnelbarriere (126, 226) und die zweite magnetische Schicht (128) einen magnetischen Tunnelübergang (122, 222), MTJ, definieren,
wobei die Heusler-Verbindung aus einer Gruppe ausgewählt ist, die aus Mn₃Ge, Mn₃Al, Mn₃Ga, Mn₃In, Mn₂FeSb, Mn₂CoGe, Mn₂CoSi, Mn₂CuSi, Mn₂CoSn, Co₂CrAl, Co₂CrSi, Co₂MnSb, und Co₂MnSi besteht, oder wobei die Heusler-Verbindung eine ternäre Heusler-Verbindung ist, die aus einer Mangan-Kobalt-ZinnGruppe ausgewählt ist, die aus Mn_{3.3-x}Co_{1.1-y}Sn besteht, wobei x ≤ 1.2 und y ≤ 1.0, oder wobei die erste magnetische Schicht (120, 220) aus Verbindungen von Mn₃Z gebildet ist, wobei:
Z ein Element ist, das aus einer Gruppe ausgewählt ist, die aus Germanium, Ge, Zinn, Sn, und Antimon, Sb besteht; und
die Verbindungen von Mn₃Z aus einer Gruppe ausgewählt sind, die aus Mn_{3.3-x}Ge, Mn_{3.3-x}Sn, und Mn_{3.3-x}Sb besteht, wobei x in einem Bereich von 0 bis 1.1 liegt.

2. MRAM-Stapel (100, 200, 300) nach Anspruch 1, wobei:
die Tunnelbarriere (126, 226) aus Verbindungen gebildet ist, die aus einer Gruppe ausgewählt sind, die aus MgO und Mg_{1-z}Al_{2+(2/3)z}O₄ besteht, wobei -0.5 < z < 0.5.

3. MRAM-Stapel (100, 200, 300) nach Anspruch 1 oder 2, wobei die erste magnetische Schicht (120) eine Dickenrichtung definiert, und wobei:
die erste magnetische Schicht (120) eine Magnetisierung aufweist, die in der Dickenrichtung orientiert ist; und
die erste magnetische Schicht (120) eine Dicke von weniger als 5 Nanometern, nm, aufweist.

4. MRAM-Stapel (100, 200, 300) nach einem der Ansprüche 1 bis 3, wobei:
die Schicht der binären Legierung, die PtAl aufweist, eine CsCl-artige Struktur aufweist, ausgewählt aus einer Platin-Aluminium-Gruppe, die aus PtₓAl₁₋ₓ besteht, wobei 0.4 < x < 0.6.

5. Verfahren zum Herstellen eines magnetischen Direktzugriffsspeicher, MRAM,-Stapels (100, 200, 300), aufweisend:
Ausbilden einer oder mehrerer Keimschichten (104, 204), aufweisend:
Ausbilden einer Vorlagenstruktur (118) über einem Substrat (102, 202), wobei die Vorlagenstruktur (118) eine Kristallstruktur aufweist, wobei das Ausbilden der Vorlagenstruktur (118) Folgendes aufweist:
Ausbilden einer Schicht einer binären Legierung, die Platin-Aluminium, PtAl, aufweist; und
Ausbilden einer ersten magnetischen Schicht (120, 220), aufweisend:
Ausbilden einer Heusler-Verbindung unter Verwendung der Vorlagenstruktur (118) als Vorlage,
wobei das Verfahren ferner Folgendes aufweist:
Ausbilden einer Tunnelbarriere (126, 226) über der ersten magnetischen Schicht (120, 220); und
Ausbilden einer zweiten magnetischen Schicht (128, 228) über der Tunnelbarriere (126, 226), wodurch die Tunnelbarriere (126, 226) zwischen der ersten magnetischen Schicht (120, 220) und der zweiten magnetischen Schicht (128, 228) positioniert wird und mit diesen in Kontakt steht, wobei:
die erste magnetische Schicht (120, 220) eine Speicherschicht definiert;
die zweite magnetische Schicht (128, 228) eine Referenzschicht (201, 228) definiert; und
die erste magnetische Schicht (120, 220), die Tunnelbarriere (126, 226) und die zweite magnetische Schicht (128, 228) einen magnetischen Tunnelübergang (122,222), MTJ, definieren,
wobei die Heusler-Verbindung aus einer Gruppe ausgewählt ist, die aus Mn₃Ge, Mn₃Al, Mn₃Ga, Mn₃In, Mn₂FeSb, Mn₂CoGe, Mn₂CoSi, Mn₂CuSi, Mn₂CoSn, Co₂CrAl, Co₂CrSi, Co₂MnSb, und Co₂MnSi besteht, oder wobei die Heusler-Verbindung eine ternäre Heusler-Verbindung ist, die aus einer Mangan-Kobalt-ZinnGruppe ausgewählt ist, die aus Mn_{3.3-x}Co_{1.1-y}Sn besteht, wobei x ≤ 1.2 und y ≤ 1.0, oder wobei die erste magnetische Schicht (120, 220) aus Verbindungen von Mn₃Z gebildet ist, wobei:
Z ein Element ist, das aus einer Gruppe ausgewählt ist, die aus Germanium, Ge, Zinn, Sn, und Antimon, Sb besteht; und
die Verbindungen von Mn₃Z aus der Gruppe ausgewählt sind, die aus Mn_{3.3-x}Ge, Mn_{3.3-x}Sn, und Mn_{3.3-x}Sb besteht, wobei x in einem Bereich von 0 bis 1.1 liegt.

6. Verfahren nach Anspruch 5, ferner aufweisend:
Ausbilden der Heusler-Verbindung über der Vorlagenstruktur (118) unter Verwendung dieser als Vorlage.

7. Verfahren nach Anspruch 5 oder 6, wobei:
das Ausbilden der Schicht der binären Legierung, die das PtAl aufweist, Folgendes aufweist:
Ausbilden einer Schicht einer binären Legierung mit einer CsCl-artigen Struktur, ausgewählt aus einer Platin-Aluminium-Gruppe, die aus PtₓAl₁₋ₓ besteht, wobei 0.4 < x < 0.6.

## Revendications

1. Empilement de mémoire vive magnétique, MRAM, (100, 200, 300) comprenant :
une première couche magnétique (120, 230) comprenant un composé de Heusler ; et
une ou plusieurs couches germes (104, 204) comprenant :
une structure de gabarit (118) comprenant une structure cristalline configurée pour servir de gabarit au composé de Heusler, la première couche magnétique (120) étant formée sur la structure de gabarit (118), la structure de gabarit (118) comprenant :
une couche d'un alliage binaire comprenant du platine-aluminium, PtAl, l'empilement MRAM (100, 200, 300) comprenant en outre :
une deuxième couche magnétique (128, 228) ; et
une barrière tunnel (126, 226) positionnée entre, et en contact avec, au moins l'une de la première couche magnétique (120) et de la deuxième couche magnétique (128), dans lequel :
la première couche magnétique (120) comprend une couche de stockage ;
la deuxième couche magnétique (128, 228) comprend une couche de référence (201, 228) ; et
la première couche magnétique (120), la barrière tunnel (126, 226) et la deuxième couche magnétique (128) définissent une jonction tunnel magnétique (122, 222), MTJ,
le composé de Heusler étant choisi dans le groupe constitué de Mn₃Ge, Mn₃Al, Mn₃Ga, Mn₃In, Mn₂FeSb, Mn₂CoGe, Mn₂CoSi, Mn₂CuSi, Mn₂CoSn, Co₂CrAl, Co₂CrSi, Co₂MnSb, et Co₂MnSi, ou le composé de Heusler étant un composé de Heusler ternaire choisi dans le groupe manganèse-cobalt-étain constitué de Mn_{3.3-X}Co_{1.1-y}Sn, dans lequel x ≤ 1.2 et y ≤ 1.0, ou la première couche magnétique (120, 220) étant formée à partir de composés de Mn₃Z, dans lequel :
Z est un élément choisi dans le groupe constitué du germanium, Ge, de l'étain, Sn, et de l'antimoine, Sb ; et
les composés de Mn₃Z sont choisis dans le groupe constitué de Mn_{3.3-x}Ge, Mn_{3.3-x}Sn, et Mn_{3.3-x}Sb, x étant dans une plage de 0 à 1.1.

2. Empilement MRAM (100, 200, 300) selon la revendication 1, dans lequel :
la barrière tunnel (126, 226) est formée à partir de composés choisis dans le groupe constitué de MgO et de Mg_{1-z}Al_{2+(2/3)z}O₄, dans lequel -0.5 < z < 0.5.

3. Empilement MRAM (100, 200, 300) selon la revendication 1 ou 2, dans lequel la première couche magnétique (120) définit une direction d'épaisseur, et dans lequel :
la première couche magnétique (120) présente une aimantation orientée dans la direction d'épaisseur ; et
la première couche magnétique (120) a une épaisseur inférieure à 5 nanomètres, nm.

4. Empilement MRAM (100, 200, 300) selon l'une quelconque des revendications 1 à 3, dans lequel :
la couche de l'alliage binaire comprenant du PtAl présente une structure de type CsCl, choisie dans le groupe platine-aluminium constitué de PtₓAl₁₋ₓ, dans lequel 0.4 < x < 0.6.

5. Procédé de fabrication d'un empilement de mémoire vive magnétique, MRAM, (100, 200, 300) comprenant :
former une ou plusieurs couches germes (104, 204) comprenant :
former une structure de gabarit (118) au-dessus d'un substrat (102, 202), la structure de gabarit (118) comprenant une structure cristalline, la formation de la structure de gabarit (118) comprenant :
former une couche d'un alliage binaire comprenant du platine-aluminium, PtAl ; et
former une première couche magnétique (120, 220) comprenant :
former un composé de Heusler au moyen de la structure de gabarit (118),
le procédé comprenant en outre :
former une barrière tunnel (126, 226) sur la première couche magnétique (120, 220) ; et
former une deuxième couche magnétique (128, 228) sur la barrière tunnel (126, 226), plaçant ainsi la barrière tunnel (126, 226) entre la première couche magnétique (120, 220) et la deuxième couche magnétique (128, 228), et en contact avec celles-ci, dans lequel :
la première couche magnétique (120, 220) définit une couche de stockage ;
la deuxième couche magnétique (128, 228) définit une couche de référence (201, 228) ; et
la première couche magnétique (120, 220), la barrière tunnel (126, 226) et la deuxième couche magnétique (128, 228) définissent une jonction tunnel magnétique (122,222), MTJ,
le composé de Heusler étant choisi dans le groupe constitué de Mn₃Ge, Mn₃Al, Mn₃Ga, Mn₃In, Mn₂FeSb, Mn₂CoGe, Mn₂CoSi, Mn₂CuSi, Mn₂CoSn, Co₂CrAl, Co₂CrSi, Co₂MnSb, ou le composé de Heusler étant un composé de Heusler ternaire choisi dans le groupe manganèse-cobalt-étain constitué de Mn_{3.3-x}Co_{1.1-y}Sn, dans lequel x ≤ 1.2 et y ≤ 1.0, ou la première couche magnétique (120, 220) étant formée à partir de composés de Mn₃Z, dans lequel :
Z est un élément choisi dans le groupe constitué du germanium, Ge, de l'étain, Sn, et de l'antimoine, Sb ; et
les composés de Mn₃Z sont choisis dans le groupe constitué de Mn_{3.3-x}Ge, Mn_{3.3-x}Sn, et Mn_{3.3-x}Sb, x étant dans une plage de 0 à 1.1.

6. Procédé selon la revendication 5, comprenant en outre :
former le composé de Heusler sur la structure de gabarit (118) en utilisant celle-ci comme gabarit.

7. Procédé selon la revendication 5 ou 6, dans lequel :
la formation de la couche de l'alliage binaire comprenant du PtAl comprend :
former une couche d'un alliage binaire présentant une structure de type CsCl, choisie dans le groupe platine-aluminium constitué de PtₓAl₁₋ₓ, dans lequel 0.4 < x < 0.6.
